# EUROPÄISCHE PATENTSCHRIFT

(11) **EP 3 362 743 B1**
(45) Veröffentlichungstag und Bekanntmachung des Hinweises auf die Patenterteilung: **11.09.2019**
(21) Anmeldenummer: 16785111.2
(22) Anmeldetag: 14.10.2016
(51) Int. Cl.: H02S 40/44, H01L 35/24, H01L 35/32, F24S 10/70, H02S 10/10

(54) **KOMBINIERTES THERMOVOLTAIK-/PHOTOVOLTAIKMODUL UND -KOLLEKTOR MIT IONISCHEN FLÜSSIGKEITEN**
COMBINED THERMOVOLTAIC/PHOTOVOLTAIC MODULE AND COLLECTOR WITH IONIC LIQUIDS
MODULE ET COLLECTEUR COMBINÉS THERMOVOLTAÏQUE/PHOTOVOLTAÏQUE À LIQUIDES IONIQUES

(30) Priorität: 17.10.2015 DE 102015013359
(43) Veröffentlichungstag der Anmeldung: 22.08.2018
(73) Patentinhaber: Tuliport S.a.r.l., 1140 Luxemburg (LU)
(72) Erfinder: POMMERSHEIM, Rainer, 55116 Mainz (DE)
(74) Vertreter: Kruspig, Volkmar
(86) Internationale Anmeldenummer: PCT/EP2016/074683
(87) Internationale Veröffentlichungsnummer: WO 2017/064242

(56) Entgegenhaltungen:
- EP-A1- 1 331 674
- EP-A1- 2 658 003
- DE-A1-102006 033 816
- US-A1- 2011 048 489
- US-A1- 2011 186 101
- STEFANIE UHL ET AL: "Fabrication of highly-integrated thermoelectric generators based on Ionic Liquids", MATERIALS TODAY: PROCEEDINGS, Bd. 2, 1. Januar 2015 (2015-01-01), Seiten 669-674, XP055335909, DOI: 10.1016/j.matpr.2015.05.084
- NEMOTO T ET AL: "Power Generation Characteristics of MgSi Uni-Leg Thermoelectric Generator", JOURNAL OF ELECTRONIC MATERIALS, SPRINGER US, BOSTON, Bd. 41, Nr. 6, 25. Februar 2012 (2012-02-25), Seiten 1312-1316, XP035057907, ISSN: 1543-186X, DOI: 10.1007/S11664-012-1963-3

## Beschreibung

Die Erfindung bezieht sich auf ein Modul, das in Solarkollektoren integrierbar ist, und welches in der Lage ist, Wärmeenergie direkt in elektrische Energie umzuwandeln. Es basiert auf dem thermoelektrischen Effekt spezieller ionischer Flüssigkeiten, welche in Kanälen im Inneren einer elektrischen und thermischen Isolationsschicht verlaufen. Auf der Ober- und Unterseite dieser Kanäle befinden sich Elektroden aus einem elektrisch und thermisch leitenden Material, die mit der ionischen Flüssigkeit im Inneren der Kanäle im Kontakt stehen. Besteht eine Temperaturdifferenz zwischen der oberen und unteren Seite dieser Kanäle, wird eine elektrische Spannung generiert, die an den Elektroden abgegriffen werden kann. Die Kanäle haben Querschnitte beispielsweise von einigen µm bis hin zu wenigen mm. Sie sind dicht an dicht in den Modulen angeordnet und können sowohl in Reihe als auch in parallel verschaltet sein. Vereint man die Module zu einem Kollektor, können diese untereinander ebenfalls in Reihe oder parallel verschaltet werden. Die erfindungsgemäße Konstruktion kann auch mit Photovoltaikmodulen kombiniert oder direkt in diese integriert werden, was zu einer Steigerung der Energieausbeute führt. In speziellen Fällen können aus solchen Modulen auch Teile für die Elektronik gefertigt werden, wie z.B. Sensoren oder Ähnliches.

Der thermoelektrische Effekt wurde von etwa 200 Jahren von Johann Seebeck entdeckt, weshalb er auch als Seebeck-Effekt bezeichnet wird. Er führt zu einem elektrischen Stromfluss und tritt auf, wenn man zwei verschiedene elektrische Leiter in Kontakt bringt und man einen dieser Leiter erwärmt.

Heute sind eine Reihe von Modulen kommerziell erhältlich, die diesen Effekt nutzen. Sie sind oft Bestandteil so genannter thermoelektrischer Generatoren (TEG) und verwenden häufig Halbleiter. Größter Nachteil dieser Module und somit auch der aktuell erhältlichen TEG ist die Tatsache, dass sie relativ hohe Temperaturunterschiede zwischen der warmen und kalten Seite benötigen, um auf nennenswerte Energieausbeuten zu kommen. Darüber hinaus ist ihre Fertigung recht aufwändig, was zu einem relativ hohen Preis führt.

Seit mehreren Jahren ist bekannt, dass nicht nur metallische Leiter und Halbleiter einen thermoelektrischen Effekt aufweisen, sondern auch einige spezielle so genannte ionische Flüssigkeiten. Ionische Flüssigkeiten sind im Grunde Salzschmelzen mit Schmelzpunkten unter 100°C. Um eine Assoziation niedriger Temperaturen mit dem Wort Schmelze zu vermeiden, werden sie als ionische Flüssigkeiten bezeichnet. Ionische Flüssigkeiten bestehen aus Kationen und Anionen, wie z.B.:

| **Kationen** | | **Anionen** |
|---|---|---|
| | | BF₄⁻ PF₆⁻ |
| 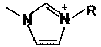 | NR₄⁺ PR₄⁺ | NO₃⁻ SO₄²⁻ CF₃SO₃⁻ |
| | | CuCl₂⁻ AlCl₄⁻ |

Je nach gewählter Kation/Anion-Kombination sind die physikalischen und chemischen Eigenschaften einer ionischen Flüssigkeit sehr unterschiedlich. Alle ionischen Flüssigkeiten haben jedoch definitionsgemäß folgende Eigenschaften gemeinsam:
- Sie bestehen ausschließlich aus Ionen;
- Sie sind unter 100°C flüssig;
- Sie verdampfen unterhalb ihrer thermischen Zersetzung nicht;
- Sie sind nicht brennbar;
- Sie sind elektrisch leitend.

Ionische Flüssigkeiten sind seit Jahrzehnten bekannt. Sie wurden für Anwendungen als Flüssigelektrolyt in der Elektrochemie entwickelt. Gegenstand der Forschungen waren zunächst jedoch nur sehr wasser- und luftempfindliche Schmelzen auf Aluminiumchloridbasis. Der Durchbruch wurde erst 1992 erzielt mit der Entdeckung luftstabiler und weniger hydrolyseempfindlicher ionischer Flüssigkeiten wie den Tetrafluoroboratschmelzen. Seit Ende der 1990er Jahre werden ionische Flüssigkeiten mit stetig wachsender Variationsbreite auch kommerziell hergestellt.

In der Fachliteratur findet man zunehmend Veröffentlichungen, die den thermoelektrischen Effekt bei einigen ionischen Flüssigkeiten beschreiben. So befassen sich beispielsweise Theodore J. Abraham, Douglas R. MacFarlane and Jennifer M. Pringle in ihrer Publikation "High Seebeck coefficient redox ionic liquid electrolytes for thermal energy harvesting" aus Energy Environ. Sci., 2013, 6, 2639-2645 mit den so genannten Seebeck-Koeffizienten einiger ionischer Flüssigkeiten. Andere Literaturstellen haben TEG auf der Basis von ionischen Flüssigkeiten zum Gegenstand. Die darin beschriebenen Aufbauten sind allerdings in erster Linie Messaufbauten zur Ermittlung physikalischer Werte und weniger als Elemente zur technischen Energiegewinnung geeignet, wie auch jener aus der in der Publikation "Ionic Liquid-based Thermoelectric Generator Links between Liquid Data and Generator Characteristics", aus: Materials Today: Proceedings 2 (2015) 680 - 689.

In der Veröffentlichung "Development of Flexible Micro-Thermo-electrochemical Generators Based on Ionic Liquids", erschienen 2014 in Journal of Electronic Materials, DOI: 10.1007/s11664-014-3126-1, wird ein Aufbau beschrieben, bei dem zwei unterschiedliche ionische Flüssigkeiten zum Einsatz kommen. Mit diesen Flüssigkeiten werden kleine Töpfchen befüllt, die untereinander in Reihe verschaltet sind. So wie das Konstrukt beschrieben ist, hat es den Nachteil, dass es sehr schwierig zu fertigen ist und aufgrund der geringen Menge an ionischen Flüssigkeiten pro Töpfchen vermutlich auch nur eine geringe Leistung erzielten kann. Die Publikation STEFANIE UHL ET AL: "Fabrication of highly-integrated thermoelectric generators based on lonic Liquids",MATERIALS TODAY: PROCEEDINGS, Bd. 2, 1. Januar 2015 (2015-01-01), Seiten 669-674, XP055335909,DOI: 10.1016/j.matpr.2015.05.084 offenbart ebenfalls eine TEG auf Basis von ionischen Flüssigkeiten.

Die Idee, TEG in Solaranlagen mit handelsüblichen Modulen zu kombinieren, ist literaturbekannt und auch Gegenstand mehrerer Patentanmeldungen. In Ermangelung von Alternativen kommen bei allen vorgefundenen Schutzrechten klassische Module auf Metall- oder Halbleiterbasis zu Einsatz. Solche TEG-Module benötigen relativ hohe Temperaturunterschiede, um auf nennenswerte Energieausbeuten zu kommen, die jedoch mit Solarmodulen in der Praxis nur schwer zu erreichen sind.

So beschreibt beispielsweise die Offenlegungsschrift DE102006033816A1 ein System, welches aus einem Solarthermiemodul und einem TEG besteht. Erfindungsgemäß wird mit dem Solarmodul eine Flüssigkeit erwärmt, die in einen Wärmetauscher gepumpt wird, in welchen der TEG integriert ist.

Die Anmeldung DE102008008652A1 beschreibt einen so genannten thermoelektrischen Akkumulator. Bei diesem Aufbau stehen mehrere TEG im Kontakt mit einem Solarthermiekollektor. Entsprechend der Beschreibung ist der Akkumulator insbesondere dafür vorgesehen, in effizienter Weise eine Enthalpieströmung mit kontinuierlich sich verändernder Temperatur, wie sie im Zirkulationskreislauf solarthermischer Anlagen vorkommt, zur elektrischen Energiegewinnung einzusetzen. In DE102008009979A1 wird eine Anordnung von TEG Modulen beschrieben, die auf der Unterseite eines Solarkollektors angebracht sind. Durch den Temperaturunterschied, der durch den Solarkollektor generiert wird, erzeugen die TEG elektrische Energie.

Bei der in WO2013183074A1 beschriebenen Erfindung sind mehrere TEG Module zu einer Einheit zusammengefasst. Der erforderliche Temperaturunterschied kommt dadurch zustande, dass nur die Oberseite der Module unter einer Glasabdeckung der Sonneneinstrahlung ausgesetzt ist, wodurch elektrische Energie generiert wird. Ausgehend von diesem Stand der Technik liegt der vorliegenden Erfindung die Aufgabe zu Grunde, ein System zu beschreiben, das auf dem thermoelektrischen Effekt von ionischen Flüssigkeiten basiert und welches die Grundlage für Module zu Gewinnung elektrischer Energie darstellt, welche industriell in Serie gefertigt werden können. Die auf diesem System basierenden Konstruktionen können entweder als eigenständige Module ausgestaltet werden, die Wärme direkt in elektrische Energie umwandeln, oder aber als Teil bestehender Photovoltaikmodule deren Ausbeute an elektrischer Energie steigern.

Die Grundidee der Erfindung besteht darin, einen Träger aus einem elektrisch und thermisch isolierenden Material zu fertigen, der eine Reihe von parallel verlaufenden Kanälen aufweist. Diese Kanäle werden mit einer oder zwei unterschiedlichen, geeigneten ionischen Flüssigkeiten befüllt. Die Ober- und Unterseite eines jeden Kanals ist von einem thermisch und elektrisch leitenden Material, wie z.B einem Metall verschlossen, welches im unmittelbaren Kontakt zu der ionischen Flüssigkeit aus dem Kanal steht. Im Falle eines Temperaturunterschiedes zwischen der oberen und unteren Seite des betreffenden Kanals wird eine elektrische Spannung generiert, die über die elektrisch leitende Ober- und Unterseite abgegriffen werden kann. Die Geometrie des Querschnittes der Kanäle wird von der angewandten Fertigungstechnik bestimmt und kann sowohl rund, quadratisch, rechteckig, dreieckig sein oder auch andere Formen aufweisen.

Für bestimmte ionische Flüssigkeiten können bei Temperaturunterschieden zwischen der Ober- und Unterseite der Kanäle von nur einigen zehn Grad Celsius Spannungen im Bereich zweistelliger mV Werte pro Kanal gemessen werden. Will man höhere Spannungen erzielen, müssen die Kanäle in Reihe geschaltet werden. Werden alle Kanäle mit der gleichen ionischen Flüssigkeit befüllt, muss die Verschaltung der Kanäle durch elektrisch leitende, externe Verbindungselemente erfolgen. Die Beschaffenheit der Verbindungselemente muss so gewählt werden, dass sie keine Wärmebrücken zwischen der Ober- und Unterseite der Kanäle bilden.

Die Konstruktion kann vereinfacht werden, wenn man je zwei benachbarte Kanäle abwechselnd mit zwei unterschiedlichen ionischen Flüssigkeiten befüllt. Aus der Laborpraxis ist bekannt, dass es ionische Flüssigkeiten gibt, die z.B. bei einer warmen Oberseite des Kanals dort eine positive Spannung generieren und auf der kälteren Unterseite eine negative. Nachfolgend sind diese ionischen Flüssigkeiten als Typ - 1 IL bezeichnet. Derlei ionische Flüssigkeiten sind z.B. chemische Verbindungen des Typs [HMIM][X]. Wobei X ein Halogenid-Ion wie z.B. I-; Cl- usw. sein kann. Bei anderen ionischen Flüssigkeiten verhält es sich genau umgekehrt. Wird die Oberseite des Kanals erwärmt, wird dort die negative Spannung generiert, während sich der Pluspol nun auf der kälteren, also unteren Seite befindet. Diese ionischen Flüssigkeiten werden nachfolgend als Typ - 2 IL bezeichnet. Es sind Verbindungen des Typs [BMIM][BF4] oder Ähnliche. Gestaltet man nun die leitenden Schichten auf den Ober- und Unterseiten der Kanäle so aus, dass sie paarweise und gleichzeitig oben und unten versetzt immer zwei Kanäle umfassen, erhält man eine konstruktiv sehr einfach zu realisierende Reihenschaltung der Kanäle.

### Ausführungsbeispiele:

### Beispiel 1:

### Einzelkanalelement

In eine Platte aus elektrisch isolierendem Material wie z.B. wie z.B. Epoxydharz, Hartpapier, Keramik oder ähnlichem wird ein runder Kanal von beispielsweise 1mm Durchmesser gefräst. Die Ober- und Untersite dieser Platte ist mit einem leitenden Material, z.B. einem Metall wie Kupfer, Silber usw. beschichtet, welche den Kanal nach oben und unten hin verschließt. Dieser Kanal wird mit einer ionischen Flüssigkeit, z.B. [BMIM][BF4] befüllt und versiegelt. Die Oberseite der Platte wird erwärmt, die Unterseite gleichzeitig gekühlt, so dass ein Temperaturunterschied von ca. 25° C entseht. In diesem Fall kann zwischen der Ober- und Untersite der Platte eine elektrische Spannung von ca. 15 mV gemessen werden. Bei einem Temperaturunterschied von ca. 10° C zwischen Ober- und Unterseite beträgt die gemessene Spannung noch ca. 5 mV.

### Beispiel 2:

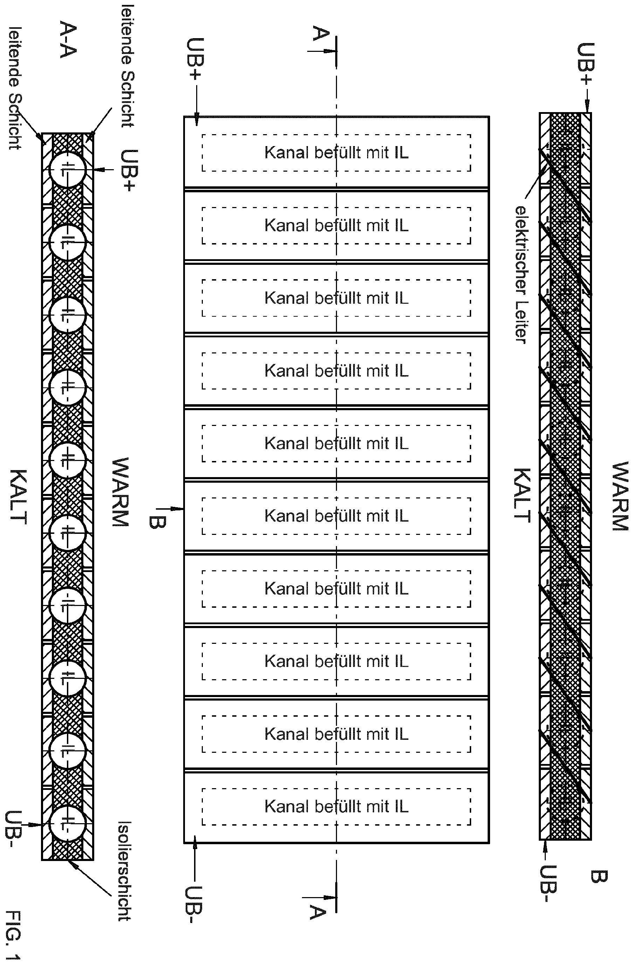

Mehrkanalelement: mit einer ionischen Flüssigkeiten (IL); Thermovoltaik (TV) Modul Ordnet man mehrere Kanäle wie in Beispiel 1 beschrieben auf einer Platte an, erhält man ein Mehrkanalelement. In Fig. 1 ist eine solche Konstruktion schematisch dargestellt. Sie zeigt den Fall eines Moduls, bei dem alle Kanäle mit der gleichen ionischen Flüssigkeit befüllt sind. Die [Isolierschicht] weist die erwähnten, parallel verlaufenden Kanäle auf. Sie besteht aus einem elektrisch und thermisch nicht oder nur schlecht leitenden Materialien wie z.B. einem Kunststoff (Epoxydharz, Melamin-Formaldehydharz, Phenol-Formaldehydharz usw.), einer Keramik, aus Glas usw. Auf der Ober- und unteres Seite der Platte befindet sich die elektrisch und thermisch [leitende Schicht]. Sie kann beispielsweise aus einem Metall bestehen, wie Kupfer, Aluminium, Silber, Gold usw., einem elektrisch und thermisch leitenden Kunststoff oder ähnlichem und ist in mehrere Streifen unterteilt. Die Kanäle in der [Isolierschicht], sind in der Zeichnung beispielhaft mit einem runden Querschnitt dargestellt. Ihr Querschnitt kann jedoch auch rechteckig, quadratisch, dreieckig, vieleckig usw. sein, und wird von den fertigungstechnischen Vorgaben bestimmt. Die Unterseite des einen Kanals ist immer mit der Oberseite den benachbarten Kanals mit einem leitenden Element verbunden. [elektrischer Leiter]. Das Material, aus dem dieses Element gefertigt ist und/oder seine Beschaffenheit, wird so gewählt, dass es zwar eine gute elektrische Leitfähigkeit aufweist, jedoch eine sehr schlechte thermische. In der Praxis kann man hierfür Metalldrähte mit relativ niedrigem Querschnitt von einigen Millimetern oder Zentimetern Länge einsetzen. Auf diese Weise werden die Kanäle elektrisch in Reihe geschaltet, so dass sich deren Spannungen addieren. Die Spannung, die bei einem Temperaturunterschied der Ober- und Unterseite generiert wird, wird an den beiden Enden [UB+] und [UB-] abgegriffen.

### Beispiel 3:

### Mehrkanalelement: mit zwei ionischen Flüssigkeiten (IL); Thermovoltaik (TV) Modul

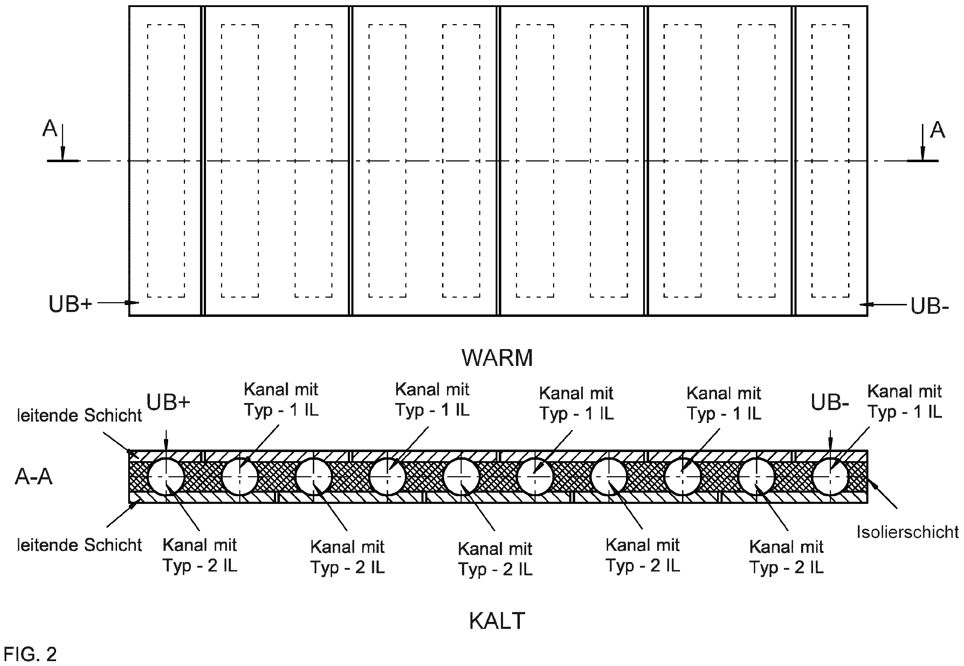

Fig. 2 zeigt den Fall eines Moduls, das mit zwei unterschiedlichen ionischen Flüssigkeiten betrieben wird. Die [Isolierschicht] weist die erwähnten parallel verlaufenden Kanäle auf. Sie besteht - wie bei Beispiel 1 und 2 auch - aus elektrisch und thermisch nicht oder nur schlecht leitenden Materialien wie z.B. einem Kunststoff (Epoxydharz, Melamin-Formaldehydharz, Phenol-Formaldehydharz usw.), einer Keramik, aus Glas usw. Auf der Ober- und Unterseite der Platte befindet sich die elektrisch und thermisch [leitende Schicht]. Sie kann beispielsweise aus einem Metall bestehen, wie Kupfer, Aluminium, Silber, Gold usw., einem elektrisch und thermisch leitenden Kunststoff oder ähnlichem und ist in mehrere Streifen unterteilt. Auch hier sind Kanäle in der [Isolierschicht], in der Zeichnung beispielhaft mit einem runden Querschnitt dargestellt. Ihr Querschnitt kann jedoch auch rechteckig, quadratisch, dreieckig, vieleckig usw. sein und wird von den fertigungstechnischen Vorgaben bestimmt. Die Kanäle sind abwechselnd mit ionischen Flüssigkeiten des Typs 1 oder 2 befüllt ([Kanal mit Typ -1 IL], [Kanal mit Typ 2 - IL]). Aufgrund der Tatsache, dass die Streifen der [leitenden Schicht] immer je zwei Kanäle miteinander verbinden, die mit ionischen Flüssigkeiten unterschiedlichen Typs befüllt sind, sind die Kanäle elektrisch in Reihe geschaltet, so dass sich deren Spannungen addieren. Die Spannung, die bei einem Temperaturunterschied der Ober- und Unterseite generiert wird, wird an den beiden Enden [UB+] und [UB-] abgegriffen.

### Beispiel 4:

### Kombiniertes Photovoltaik (PV) / Thermovoltaik (TV) Modul

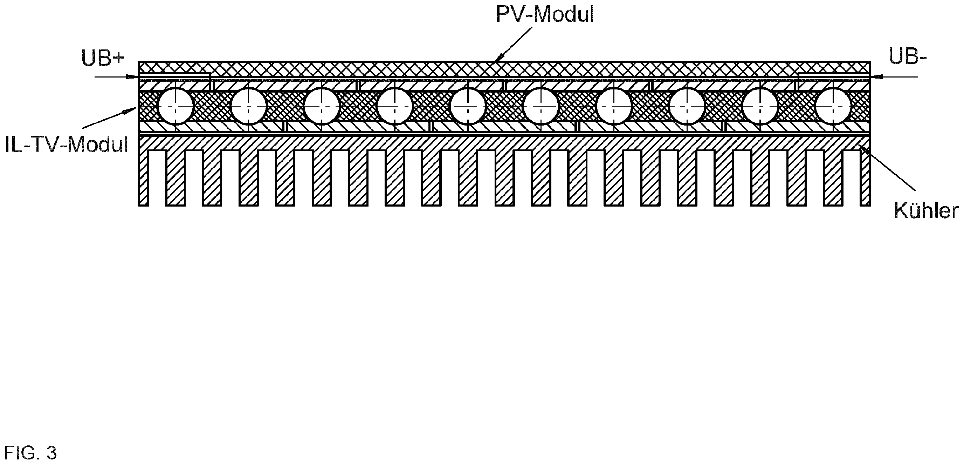

Fig 3 zeigt beispielhaft ein Thermovoltaik Modul, wie es in Beispiel 3 beschrieben [IL-TV-Modul] ist, und welches mit einem Photovoltaik Modul [PV Modul] kombiniert wurde. Eine ähnliche Konstruktion kann auch mit dem Modul aus Beispiel 2 realisiert werden. Das [IL-TV-Modul] wird dabei auf der Unterseite des [PV-Moduls] angebracht. Das kann z.B. durch Verkleben, Verschrauben oder jeder anderen geeigneten Verbindungstechnik erfolgen. Die Elektroden des [IL-TV-Moduls] und jene das [PV-Moduls] sind elektrisch im Kontakt, so dass sich die an [UB+] und [UB-] abgegriffene Spannung aus der des [IL-TV-Moduls] und jener das [PV-Moduls] zusammensetzt. Der elektrische Kontakt zwischen dem [IL-TV-Modul] und dem [PV-Modul] kann, er muss aber nicht unmittelbar erfolgen. Er kann auch über geeignete elektronische Bauteile oder Schaltungen hergestellt werden. Auf der Unterseite des [IL-TV-Moduls] ist ein Kühler befestigt. Beispielhaft ist in der Zeichnung ein Rippenkühler aus Metall dargestellt. In der Praxis kann jedoch jedes andere kühlende Element zum Einsatz kommen. Vorteilhaft sind Kühlelemente, die mit so genannten Heat-Pipes ausgestattet sind. Diese können die Wärme schnell und effizient vom Modul wegleiten und so für eine optimale Kühlung sorgen. Derlei Kühlelemente können auch mit der Halterung des Moduls kombiniert werden. In jedem Fall ist darauf zu achten, dass weder das [PV-Modul] noch der [Kühler] die leitenden Schichten des [IL-TV-Moduls] elektrisch kurz schließen. Eventuell sind dazwischen Folien oder Platten von elektrisch isolierenden Materialien mit einer guten Wärmeleitfähigkeit wir Glimmer, spezielle Kunststoffe oder Lacke usw. anzubringen oder aufzutragen.

### Beispiel 5:

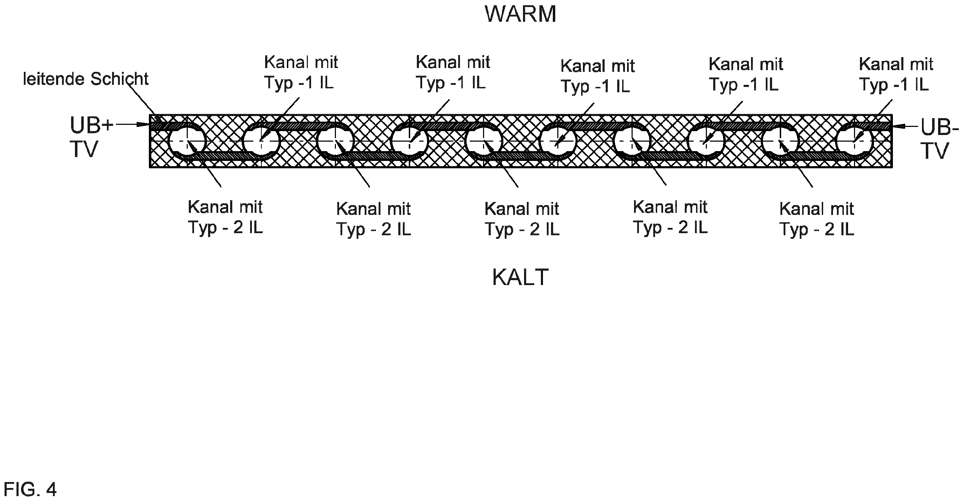

Erfindungsgemässes Kombiniertes Photovoltaik (PV) / Thermovoltaik (TV) mit integrierten Kanälen Geht man fertigungstechnisch einen Schritt weiter, kann man ein kombiniertes Photovoltaik (PV) / Thermovoltaik (TV) Modul herstellen, bei dem die Kanäle direkt in das PV-Modul integriert sind. Ein solches Modul ist in Fig. 4 schematisch dargestellt. Obwohl hier der Fall eines Moduls gezeigt wird, das mit zwei unterschiedlichen ionische Flüssigkeiten betrieben wird, kann ein ähnlicher Aufbau auch nach dem Prinzip eines Mehrkanalelements mit einer ionischen Flüssigkeit realisiert werden, welches in Beispiel 2 beschrieben wird. In diesem Fall ist dann die Form der [leitenden Schicht] so zu verändern, dass sie nur einen Kanal umfasst. Auch sind dann die einzelnen Metallschichten, wie in Beispiel 2 gezeigt, elektrisch zu verbinden. Baut man das Modul nach dem Prinzip eines Mehrkanalelementes mit zwei unterschiedlichen ionischen Flüssigkeiten wie in Beispiel 3 beschrieben, vereinfacht sich die Konstruktion, da die zusätzlichen elektrischen Leiter, die jeweils Ober- und Unterseite der [leitenden Schicht] verbinden, entfallen. Der große Vorteil dieser Konstruktion gegenüber jener aus Beispiel 4 ist, dass man hier die Kanäle mit den ionischen Flüssigkeiten direkt in den Grundkörper des Photovoltaik-Moduls integriert und einen viel besseren Wärmeübergang gewährleistet. Die elektrische Energie, die aufgrund des thermoelektrischen Effektes in dem Modul erzeugt wird, addiert sich zu jener, die durch den photoelektrischen Effekt erhalten wird, was die Ausbeute des Moduls steigert. Ähnlich wie in Beispiel 4 gezeigt, kann auch dieser Aufbau auf der Unterseite mit einem Kühlelement versehen werden, welches ebenfalls auch Heat-Pipes beinhalten kann.

## Patentansprüche

1. System, das auf dem thermoelektrischen Effekt so genannter ionischer Flüssigkeiten basiert und welches in der Lage ist, Wärmeenergie direkt in elektrische Energie umzuwandeln, aufweisend ein kombiniertes Photovoltaik- und Thermovoltaikmodul, wobei
das System aus einem oder mehreren kombinierten Photovoltaik- und Thermovoltaikmodul(en) besteht,
wobei sich im Inneren eines kombinierten Photovoltaik- und Thermovoltaikmodul parallel verlaufende Kanäle befinden, die direkt in das kombinierte Photovoltaik- und Thermovoltaikmodul integriert sind, wobei die Kanäle mit ionischen Flüssigkeiten befüllt sind und so aufgebaut oder angeordnet sind, dass sie mindestens ein kombiniertes Photovoltaik- und Thermovoltaikmodul bilden, wobei das kombinierte Photovoltaik- und Thermovoltaikmodul
- eine elektrisch und thermisch isolierende Schicht besitzt, in welche die parallel verlaufenden Kanäle eingearbeitet sind, die mit ionischen Flüssigkeiten befüllt sind,
- an der Ober- und Unterseite der elektrisch und thermisch isolierenden Schicht, sich mindestens je eine elektrisch und thermisch leitende Schicht befindet, die mit den ionischen Flüssigkeiten im Inneren der Kanäle im thermischen und elektrischen Kontakt steht
- die elektrisch und thermisch leitenden Schichten an der Ober- und Unterseite der elektrisch und thermisch isolierenden Schicht als Elektroden dienen, an denen eine elektrische Spannung abgegriffen werden kann, sofern ein Temperaturunterschied zwischen der oberen und unteren elektrisch und thermisch leitenden Schicht besteht.

2. System nach Anspruch 1,
**dadurch gekennzeichnet, dass** die parallel verlaufenden Kanäle im Inneren der elektrisch und thermisch isolierenden Schicht Durchmesser im Bereich von beispielsweise wenigen µm bis hin zu wenigen mm aufweisen und eine runde, quadratische, dreieckige, vieleckige oder unregelmäßige Form der Querschnittes besitzen.

3. System nach Anspruch 1 bis 2,
**dadurch gekennzeichnet, dass** alle parallel verlaufenden Kanäle im Inneren der elektrisch und thermisch isolierenden Schicht mit der gleichen ionischen Flüssigkeit befüllt sind.

4. System nach Anspruch 1 bis 3,
**dadurch gekennzeichnet, dass** zwei benachbarte, parallel verlaufenden Kanäle im Inneren der elektrisch und thermisch isolierenden Schicht mit zwei unterschiedlichen ionischen Flüssigkeiten (Typ-1 IL und Typ-2 IL) befüllt sind, die in den jeweiligen elektrisch und thermisch leitenden Schichten, Spannungen von umgekehrter Polarität erzeugen.

5. System nach Anspruch 1 bis 4,
**dadurch gekennzeichnet, dass** seine elektrisch und thermisch leitenden Schichten entweder nur einen Kanal umfassen oder mehrere Kanäle gleichzeitig und welche entweder über externe elektrisch leitende Elemente einen elektrischen Kontakt zwischen den ionischen Flüssigkeiten im Inneren unterschiedlicher Kanäle herstellen oder selbst einen elektrischen Kontakt zwischen den ionischen Flüssigkeiten unterschiedlicher Kanäle sicherstellen.

6. System nach Anspruch 1 bis 5,
**dadurch gekennzeichnet, dass** die Kanäle und somit auch die ionischen Flüssigkeiten in ihrem Inneren elektrisch entweder in Reihe oder parallel verschaltet sein können.

7. System nach Anspruch 1 bis 6, **dadurch gekennzeichnet, dass** das mindestens eine Modul auf der Unterseite in direktem thermischen Kontakt zu einem Kühlelement steht.

8. System nach Anspruch 7,
**dadurch gekennzeichnet, dass** das Kühlelement mit Heat-Pipes ausgestattet ist.

## Claims

1. A system which is based on the thermoelectric effect of so-called ionic liquids and is capable of converting thermal energy directly into electric energy, comprising a combined photovoltaic and thermovoltaic module, wherein
the system is comprised of one or more combined photovoltaic and thermovoltaic modules,
wherein in the interior of a combined photovoltaic and thermovoltaic module, channels extending in parallel are present, which are directly integrated into the combined photovoltaic and thermovoltaic module, wherein the channels are filled with ionic liquids and are constructed or arranged so as to form at least one combined photovoltaic and thermovoltaic module, wherein the combined photovoltaic and thermovoltaic module
- has an electrically and thermally isolating layer in which the channels extending in parallel are incorporated, which are filled with ionic liquids,
- at the upper and lower side of the electrically and thermally isolating layer, in each case at least one electrically and thermally conducting layer is present which is in thermal and electrical contact with the ionic liquids within the channels,
- the electrically and thermally conducting layers at the upper and lower side of the electrically and thermally isolating layer serve as electrodes where an electrical voltage can be tapped if there is a temperature difference between the upper and lower electrically and thermally conducting layer.

2. The system according to claim 1,
**characterized in that** the channels extending in parallel in the interior of the electrically and thermally isolating layer have diameters in the range of, for example, a few µm up to a few mm, and have a circular, square, triangular, polygonal or irregular form of cross-section.

3. The system according to claim 1 to 2,
**characterized in that** all of the channels extending in parallel in the interior of the electrically and thermally isolating layer are filled with the same ionic liquid.

4. The system according to claim 1 to 3,
**characterized in that** two adjacent channels extending in parallel in the interior of the electrically and thermally isolating layer are filled with two different ionic liquids (type 1 IL and type 2 IL) which generate voltages of reversed polarity in the respective electrically and thermally conducting layers.

5. The system according to claim 1 to 4,
**characterized in that** its electrically and thermally conducting layers either comprise only one channel or a plurality of channels at the same time, and which establish an electrical contact between the ionic liquids in the interior of different channels either via external electrically conducting elements or ensure themselves an electrical contact between the ionic liquids in the interior of different channels.

6. The system according to claim 1 to 5,
**characterized in that** the channels and thus also the ionic liquids in their interior may be electrically connected in series or in parallel.

7. The system according to claim 1 to 6,
**characterized in that** the at least one module, at the underside, is in direct thermal contact to a cooling element.

8. The system according to claim 7,
**characterized in that** the cooling element is equipped with heat pipes.

## Revendications

1. Système qui est basé sur l'effet thermoélectrique de liquides dits ioniques et qui est capable de convertir directement l'énergie thermique en énergie électrique, comprenant un module photovoltaïque et thermovoltaïque combiné,
dans lequel
le système se compose d'un ou plusieurs modules photovoltaïques et thermovoltaïques combinés,
des canaux parallèles sont situés à l'intérieur d'un module photovoltaïque et thermovoltaïque combiné et sont directement intégrés dans le module photovoltaïque et thermovoltaïque combiné,
les canaux sont remplis de liquides ioniques et sont construits ou disposés de manière à former au moins un module photovoltaïque et thermovoltaïque combiné, et
le module photovoltaïque et thermovoltaïque combiné
- possède une couche d'isolation électrique et thermique dans laquelle sont incorporés les canaux parallèles remplis de liquides ioniques,
- sur la face supérieure et inférieure de la couche d'isolation électrique et thermique, il est prévu au moins une couche électriquement et thermiquement conductrice, qui est en contact thermique et électrique avec des liquides ioniques à l'intérieur des canaux,
- les couches électriquement et thermiquement conductrices situées sur la face supérieure et inférieure de la couche d'isolation électrique et thermique servent d'électrodes auxquelles une tension électrique peut être prélevée, à condition qu'il y ait une différence de température entre les couches électriquement et thermiquement conductrices supérieure et inférieure.

2. Système selon la revendication 1,
**caractérisé en ce que**
les canaux parallèles à l'intérieur de la couche d'isolation électrique et thermique présentent des diamètres dans la plage par exemple de quelques µm à quelques mm,
et présentent une forme en section transversale ronde, carrée, triangulaire, polygonale ou irrégulière.

3. Système selon la revendication 1 à 2,
**caractérisé en ce que**
tous les canaux parallèles à l'intérieur de la couche d'isolation électrique et thermique sont remplis avec le même liquide ionique.

4. Système selon la revendication 1 à 3,
**caractérisé en ce que**
deux canaux parallèles voisins à l'intérieur de la couche d'isolation électrique et thermique sont remplis avec deux liquides ioniques différents (type-1 IL et type-2 IL) qui génèrent des tensions de polarité inversée dans les couches respectives électriquement et thermiquement conductrices.

5. Système selon la revendication 1 à 4,
**caractérisé en ce que**
ses couches électriquement et thermiquement conductrices comprennent soit un seul canal soit plusieurs canaux simultanément et établissent un contact électrique entre les liquides ioniques à l'intérieur de différents canaux par des éléments externes électriquement conducteurs ou alors assurent elles-mêmes un contact électrique entre les liquides ioniques de différents canaux.

6. Système selon la revendication 1 à 5,
**caractérisé en ce que**
les canaux et donc également les liquides ioniques peuvent être connectés électriquement soit en série soit en parallèle, dans leur intérieur.

7. Système selon la revendication 1 à 6,
**caractérisé en ce que**
sur la face inférieure, ledit au moins un module est en contact thermique direct avec un élément de refroidissement.

8. Système selon la revendication 7,
**caractérisé en ce que**
l'élément de refroidissement est muni de caloducs.
